# EUROPEAN PATENT APPLICATION

(11) **EP 4 681 968 A1**
(43) Date of publication of application: **21.01.2026**
(21) Application number: 24913636.7
(22) Date of filing: 20.12.2024
(51) Int. Cl.: B60L 3/00, G01R 31/392, G01R 31/396, G01R 31/389, G01R 31/382

(54) **BATTERY TEST DEVICE AND BATTERY TEST METHOD**

(30) Priority: 27.12.2023 KR 20230193112
(71) Applicant: LG Energy Solution, Ltd., Seoul 07335 (KR)
(72) Inventor: LEE, Ji Hyun, Daejeon 34122 (KR); KIM, Young Soon, Daejeon 34122 (KR); LEE, Jeong Min, Daejeon 34122 (KR); NOH, Hyung Jun, Daejeon 34122 (KR)
(74) Representative: Goddar, Heinz J.
(86) International application number: PCT/KR2024/020807
(87) International publication number: WO 2025/143693

(57) **Abstract**

A battery test device disclosed herein includes a communication unit configured to acquire battery data from a battery cell, and a control unit configured to determine a verification driving pattern related to a test of the battery cell, test the battery cell using the verification driving pattern to acquire test data in the battery test device reflecting a temperature difference of the battery cell, compare standard capacity change rates and resistance change rates of a first driving mode and a second driving mode, which are acquired based on the test data, and determine a life influence degree of the battery cell.

## Description

### TECHNICAL FIELD

### CROSS-REFERENCE TO RELATED APPLICATION

This application claims priority to and the benefit of Korean Patent Application No. 10-2023-0193112 filed in the Korean Intellectual Property Office on December 27, 2023, the entire contents of which are incorporated herein by reference.

### TECHNICAL FIELD

Embodiments disclosed herein relate to a battery test device and a battery test method.

### BACKGROUND ART

Recently, research and development on secondary batteries has been actively conducted. Here, the secondary battery is a battery capable of charging and discharging and includes all recent lithium ion batteries in addition to conventional Ni/Cd batteries and Ni/MH batteries. Among secondary batteries, lithium-ion batteries have an advantage of having a much higher energy density than conventional Ni/Cd batteries, Ni/MH batteries, etc. In addition, the lithium-ion batteries may be manufactured in a compact and lightweight form, and thus are used as a power source for a mobile device. In addition, the lithium-ion batteries are attracting attention as a next-generation energy storage medium as a range of use expands to a power source for an electric vehicle.

As the demand for these batteries increases, the advancement of battery test algorithms for verifying performance of the batteries is essential, and when the batteries are used in high-temperature environments such as high-powered vehicles, verification of battery safety is directly related to the safety of battery users. However, general battery test algorithms have a problem that a use environment of a battery cannot be simulated, thereby causing an error in a life influence degree of a battery, which occur when actually using batteries.

### DISCLOSURE

### TECHNICAL PROBLEM

One embodiment disclosed herein is directed to providing a battery test device and a battery test method, which perform a battery test by simulating an environment in which a battery cell is used at a high temperature.

The technical objects of the embodiments disclosed herein are not limited to the above-described technical objects, and other objects that are not mentioned will be able to be clearly understood by those skilled in the art from the following descriptions.

### TECHNICAL SOLUTION

A battery test device according to one embodiment may include a battery test device including a communication unit configured to acquire battery data from a battery cell, and a control unit configured to determine a verification driving pattern related to a test of the battery cell, reflect a temperature difference of the battery cell to acquire test data, acquire a standard capacity change rate and a resistance change rate of the battery cell in each of a first driving mode and a second driving mode based on the test data, and compare the standard capacity change rates and the resistance change rates to determine a life influence degree of the battery cell.

The control unit may compare the standard capacity change rates and the resistance change rates based on the temperature difference of the battery cell in the first driving mode and the second driving mode being a reference difference or more.

The control unit may determine the life influence degree of the battery cell based on a time for which the temperature difference exceeds the reference difference being a reference time or longer.

The control unit may determine the life influence degree based on a condition in which driving of the battery cell is stopped being satisfied within the reference time.

The control unit may acquire the test data from a simulation kit including a plurality of temperature sensors.

The control unit may acquire the test data from the simulation kit including a heating pad formed so that one surface of the battery cell reaches a preset first threshold temperature and a cooling line formed so that the other surface of the battery cell reaches a preset second threshold temperature.

The control unit may acquire the test data from the simulation kit provided so that an insulation pad formed to retain a temperature of the battery at a predetermined temperature or higher surrounds the battery cell.

The verification driving pattern may include a driving pattern of a case in which a vehicle drives with the battery cell having highest power within a drivable range of the battery cell.

A battery test method according to one embodiment includes acquiring battery data from a battery cell, determining a verification driving pattern related to a test of the battery cell, reflecting a temperature difference of the battery cell to acquire test data, acquiring a standard capacity change rate and a resistance change rate of the battery cell in each of a first driving mode and a second driving mode based on the test data, and comparing the standard capacity change rates and the resistance change rates to determine a life influence degree of the battery cell.

A battery test system according to one embodiment includes a battery cell included in a battery module, a simulation kit configured to reflect a temperature difference of the battery cell, and a battery test device configured to reflect the temperature difference to acquire test data obtained by testing the battery cell with the verification driving pattern, acquire a standard capacity change rate and a resistance change rate of the battery cell in each of a first driving mode and a second driving mode based on the test data, compare the standard capacity change rates and the resistance change rates, and determine a life influence degree of the battery cell in each of the first driving mode and the second driving mode.

The battery test device may compare the standard capacity change rates and the resistance change rates based on the temperature difference of the battery cell in the first driving mode and the second driving mode being a reference difference or more.

The battery test device may determine the life influence degree of the battery cell based on a time for which the temperature difference exceeds the reference difference being a reference time or longer.

The battery test device may determine the life influence degree based on a condition in which driving of the battery cell is stopped being satisfied within the reference time.

The simulation kit may include a plurality of temperature sensors configured to detect the temperature difference of the battery cell.

The simulation kit may include a heating pad formed so that one surface of the battery cell retains a preset first threshold temperature and a cooling line formed so that the other surface of the battery cell retains a preset second threshold temperature.

The simulation kit may be provided so that an insulation pad formed to retain a temperature of the battery at a predetermined temperature or higher surrounds the battery cell.

The verification driving pattern may include a driving pattern of a case in which a vehicle drives with the battery cell having highest power within a drivable range of the battery cell.

### ADVANTAGEOUS EFFECTS

According to the battery test device according to one embodiment, it is possible to pre-verify and determine the degradation of performance of the battery and risky factors due to the high-power mode when the battery is used, thereby increasing the stability of use of the battery.

According to the battery test device according to one embodiment, when the battery is used in the high-power driving mode, it is possible to predict the degree of the performance which is degraded compared to the performance of the battery specified on the battery quality warranty in advance.

### DESCRIPTION OF DRAWINGS

FIG. 1 is a block diagram illustrating a typical battery system including a battery test device according to one embodiment.
FIG. 2 is a block diagram illustrating a configuration of the battery test device according to one embodiment.
FIG. 3 is a schematic view illustrating a flow of the battery test device verifying a battery according to one embodiment.
FIGS. 4 and 5 are views illustrating charging/discharging profiles of different driving modes used in the battery test device according to one embodiment.
FIG. 6 is a view illustrating a temperature difference occurring in the battery test device according to one embodiment.
FIG. 7 is a view illustrating a simulation kit included in the battery test device according to one embodiment.
FIG. 8 is a view illustrating a discharge capacity retention rate and a resistance increase rate considering the temperature difference by the battery test device according to one embodiment.
FIG. 9 is a view illustrating a degree of aging considering the temperature difference by the battery test device according to one embodiment.
FIG. 10 is a control flowchart of a battery test method according to one embodiment.

### MODE FOR INVENTION

Hereinafter, various embodiments disclosed herein will be described in detail with reference to the accompanying drawings. The same components in the drawings herein use the same reference numerals, and overlapping descriptions of the same components will be omitted.

For various embodiments disclosed herein, specific structural and functional descriptions are provided merely for the purpose of describing the embodiments, and various embodiments disclosed herein may be implemented in various forms and should not be construed as being limited to the embodiments described herein.

Expressions such as "first," "second," "first," and "second" used in various embodiments may indicate various components regardless of sequence and/or importance and do not limit the corresponding components. For example, a first component may be referred to as a second component, and similarly, the second component may also be referred to as the first component without departing from the scopes of the embodiments disclosed herein.

The terms used herein are used only to describe specific embodiments and may not be intended to limit the scopes of other embodiments. The singular expression includes the plural expression unless the context clearly dictates otherwise.

All terms used herein, including technical or scientific terms, may have the same meaning as commonly understood by those skilled in the art of the embodiments disclosed herein. Terms defined in commonly used dictionaries may be construed as having the same or similar meaning in the context of the relevant technology and are not construed in an ideal or overly formal sense unless explicitly defined herein. In some cases, even terms defined herein may not be construed to exclude the embodiments disclosed herein.

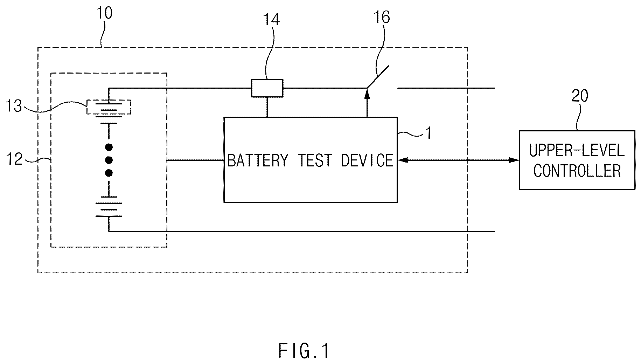

FIG. 1 is a block diagram illustrating a typical battery system including a battery test device according to various embodiments.

Specifically, FIG. 1 schematically illustrates a battery system 10 according to one embodiment disclosed herein and an upper-level controller 20 included in an upper-level system.

As illustrated in FIG. 1, the battery system 10 may include a plurality of battery modules 12, a sensor unit 14, a switching unit 16, and a battery test device 1. In this case, the battery system 10 may include the battery modules 12, the sensor units 14, the switching units 16, and the battery test devices 1.

The plurality of battery modules 12 may include one or more chargeable and dischargeable battery cells 13. The battery cell 13 may include a positive electrode, a positive electrode material, a negative electrode, a negative electrode material, a separator, an electrolyte, a polymer, and a case. In this case, the plurality of battery modules 12 may be connected in series or in parallel.

The sensor unit 14 may include a voltage sensor, a current sensor, and a temperature sensor.

The voltage sensor may be connected parallel to a battery and configured to detect a battery voltage, which is a voltage across both ends of the battery, and generate a voltage signal representing the detected battery voltage.

The voltage sensor may include at least one of a resistance distribution sensor, a Hall effect sensor, and a Shockley effect sensor for voltage measurement, and there is no limitation as long as it is a component for measuring a voltage of a battery cell.

The current sensor may detect a current used during a process of determining a state of charge (SoC) of the battery cell 13. The current sensor may include any component for generating a signal corresponding to a magnitude of a charging current, and the current sensor may be installed on a charging/discharging path, which is a path through which charging/discharging currents flow in a battery.

The current sensor may measure battery currents flowing in the battery, that is, the charging current and the discharging current, and transmit the result of the measurement to the battery test device 1. According to one embodiment, the current sensor may measure the battery current at a predetermined cycle in a charging cycle in which the battery is charged with power of an external device or a discharging cycle in which the battery is discharged, and transmit the result of the measurement to the battery test device 1.

The temperature sensor may be configured to measure a battery temperature and generate a temperature signal representing the measured battery temperature. The temperature sensor may be disposed in a case to measure a temperature close to an actual temperature of the battery. For example, the temperature sensor may be attached to a surface of at least one battery cell included in a cell group and may detect a surface temperature of the battery cell as the battery temperature.

In FIG. 1, the sensor unit 14 is connected between a positive electrode of the battery cell 13 and the switching unit 16, but the components and a connection relationship between the components illustrated in FIG. 1 are only one example and are not limited thereto.

The switching unit 16 may be connected in series to a (+) terminal side or (-) terminal side of the battery module 12 to control flows of charging/discharging currents of the battery module 12. For example, the switching unit 16 may use at least one relay, magnetic contactor, or the like depending on specifications of the battery system 10.

The battery test device 1 is an interface for receiving values measuring various parameters and may include a plurality of terminals, a circuit connected to these terminals to process the received values, and the like. In addition, the battery test device 1 may control the ON/OFF of the switching unit 16, for example, a relay, a contactor, or the like, and may be connected to the battery module 12 to monitor a state of each battery module 12.

In addition, the battery test device 1 may receive temperature data, voltage data, and current data from the sensor unit 14 to acquire battery state information and verify a state of the battery.

The upper-level controller 20 may transmit a control signal for controlling the battery module 12 to the battery test device 1. Accordingly, the operation of the battery test device 1 may be controlled based on the control signal applied from the upper-level controller 20. In addition, the battery module 12 may be a component included in an energy storage system (ESS). In this case, the upper-level controller 20 may be a controller (BBMS) of a battery bank including a plurality of battery systems 10 or an ESS controller for controlling all ESSs including a plurality of banks. However, the battery system 10 is not limited to such a purpose.

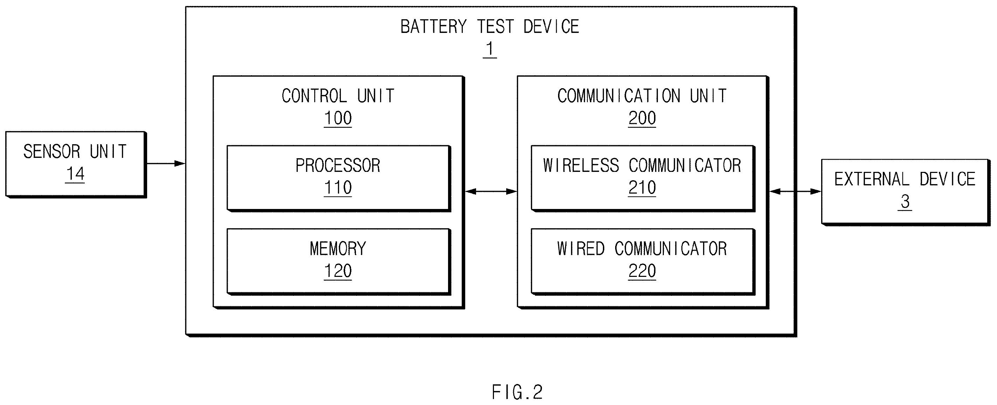

FIG. 2 is a block diagram illustrating a configuration of the battery test device according to one embodiment.

Referring to FIG. 2, the battery test device 1 according to one embodiment may include a control unit 100 including at least one processor 110 and at least one memory 120 and a communication unit 200 and test a battery in communication with an external device 4 through the communication unit 200.

According to one embodiment, the external device 3 communicating with the battery test device 1 may include a user terminal and a server device, which transmit the result tested by the battery test device 1.

Specifically, when the external device 3 is a user terminal, the control unit 100 of the battery test device 1 may transmit the result of testing the battery to the user terminal so that a user may check the result. In this case, the user terminal may include a personal computer, a terminal, a portable telephone, a smartphone, a handheld device, a wearable device, or the like, but is not limited thereto.

In addition, when the external device 3 is a server device, the server device may be implemented as any computing device such as a workstation, a cloud, a data drive, a data station, or the like. The server device may be implemented as one or more server devices physically or logically separated based on functions, specific configurations of functions, data, or the like and may transmit and receive data through communication between server devices and process the transmitted and received data.

The battery test device 1 according to one embodiment may be any electronic device including the processor 110 and the memory 120 and mounted on a vehicle and operated. Hereinafter, each component of the battery test device 1 will be described in detail.

The communication unit 200 may include a wireless communicator 210 and a wired communicator 220 to communicate with the external device 3. The communication unit 200 may transmit and receive programs or various types of data for calculating characteristic values of a battery cell, sorting a class, calculating a degree of aging, and estimating a life to and from a separately provided external server.

The wireless communicator 210 may include at least one of a short-range communication module and a long-range communication module.

The short-range communication module may communicate with the external device 3 adjacent to the battery test device 1 using a short-range communication method. Here, the short-range communication module may use one communication method of Bluetooth, Bluetooth low energy, infrared data association (IrDA), Zigbee, Wi-Fi, Wi-Fi direct, ultra-wideband (UWB), and near field communication (NFC).

The long-range communication module may include a communication module for performing various types of long-range communication and include a mobile communication unit. The mobile communication unit may transmit and receive a wireless signal with at least one of a base station, an external terminal, and the external device 3 on a mobile communication network. In addition, the long-range communication module may communicate with the external device 3, the external device 3 of another electronic device or the like through a peripheral access point (AP). The AP may connect a local area network (LAN) to which the battery test device 1 is connected to a wide area network (WAN) to which a communication server is connected. Accordingly, the battery test devices 1 may be connected to the communication server to communicate with the external device 3 via the wide area network (WAN).

The wired communicator 220 may access a wired communication network and communicate with the external device 3 through the wired communication network. For example, the wired communicator 220 may access the wired communication network through Ethernet (IEEE 802.3 technical standard) or access the wired communication network through CAN communication, and transmit and receive data with the external devices 3 via the wired communication network.

The battery test device 1 according to one embodiment may include an input/output interface (not illustrated). An interface for connecting an input device (not illustrated) such as a keyboard, a mouse, a touch panel, or the like and an output device such as a display (not illustrated) to the processor 110 to allow the input and output devices to transmit and receive data may be provided.

The memory 120 may store various pieces of information required for operating the battery test device 1. Specifically, the memory 120 may store an operating system and a program required for driving the battery test device 1 or store data required for driving the battery test device 1.

Specifically, the memory 120 may store various types of programs related to calculating the degree of aging of a battery cell and estimating a life of the battery cell. In addition, the memory 120 may store various types of battery data such as a voltage, current, temperature, characteristic value data, and the like of each battery cell.

In addition, the memory 120 may store a life influence degree of the battery cell performed by the processor 110.

The memory 120 may include the volatile memory 120 such as a static random access memory (SRAM) or dynamic random access memory (DRAM) for temporarily storing data. In addition, the memory 120 may include the nonvolatile memory 120 such as a read only memory (ROM), erasable programmable ROM (EPROM), or electrically erasable programmable ROM (EEPROM) for storing data for a long time.

The processor 110 outputs a control signal to generally control the battery test device 1. The processor 110 may include one or more central processing units (CPUs) and graphics processing units (GPUs). In this case, the processor 110 may be implemented as an array of a plurality of logic gates and implemented as a combination of a general-purpose microprocessor 110 and the memory 120 in which a program that may be executed in the microprocessor 110 is stored.

The memory 120 and the processor 110 may be included in the control unit 100, and the control unit 100 may control the above components to verify the battery cell.

Specifically, the control unit 100 may determine a verification driving pattern of the battery cell 13 and reflect a temperature difference of the battery cell 13 to acquire test data. In this case, the verification driving pattern may be selected by the control unit 100 from a plurality of driving patterns and may receive a pre-generated verification driving pattern through the communication unit 200.

Thereafter, the control unit 100 may acquire a standard capacity change rate and resistance change rate of each of first and second driving modes based on the test data, compare the standard capacity change rates and the resistance change rates, and determine a life influence degree of the battery cell 13. Here, the first driving mode may be a normal driving mode of a vehicle using a battery, and the second driving mode may be a high-power driving mode of a high-power vehicle using a battery.

Accordingly, the battery test device 1 according to one embodiment may compare standard capacity change rates and the resistance change rates of the normal driving mode and the high-power driving mode and determine a life influence degree.

Specifically, the control unit 100 may compare the standard capacity change rates and the resistance change rates based on a temperature difference of the battery cell 13 in the first driving mode and the second driving mode being greater than or equal to a reference difference, and the control unit 100 may determine the life influence degree of the battery cell 13 based on the time for which the temperature difference exceeds the reference difference being longer than or equal to a reference time.

That is, the control unit 100 may determine the life influence degree of the battery cell 13 considering the temperature difference inside the battery cell 13 in each driving mode and thus test the battery in an environment closer to actual driving.

In addition, the control unit 100 may determine the life influence degree based on a condition in which the driving of the battery cell 13 is stopped within the reference time being satisfied, and when a situation in which a temperature difference occurs due to the use of the battery in the high-power mode and thus the driving of the battery cell 13 is stopped due to the occurrence of upper and lower limits of a voltage or restriction to an upper limit of a temperature occurs, the control unit 100 may reflect such a situation to the life influence degree of the battery cell 13.

In this way, the battery test device 1 according to one embodiment may determine the life influence degree of the battery cell 13 considering not only the driving mode but also the temperature difference of the battery cell 13, and thus determine the life influence degree of the battery cell 13 before the battery is shipped, and thus the life of the battery cell 13 may be considered in the warranty of the battery.

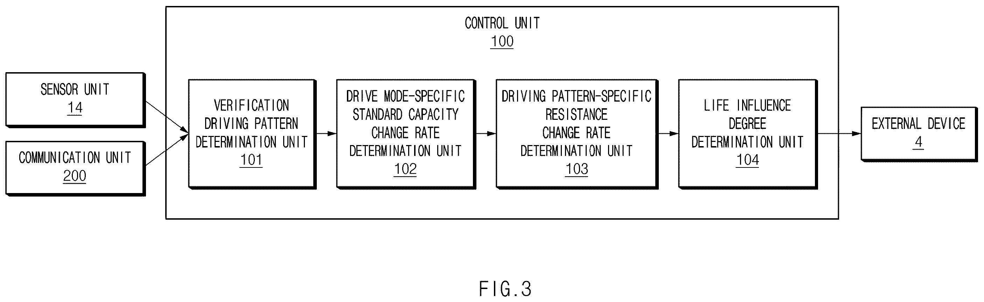

FIG. 3 is a schematic view illustrating a flow of the battery test device verifying a battery according to one embodiment.

In FIG. 3, components 101 to 104 may be implemented in the form of software blocks and stored in the memory 120 and executed by the processor 110.

Referring to FIG. 3, the control unit 100 may receive battery data of the battery cell 13 from the sensor unit 14 or the communication unit 200. The control unit 100 may receive the battery data and determine a standard capacity change rate for each driving mode and a resistance change rate for each driving mode.

Thereafter, a verification driving pattern determination unit 101 of the control unit 100 may determine a driving pattern of a vehicle for verifying the battery cell 13. For example, the verification driving pattern may include a driving pattern of a case in which the vehicle drives with the battery cell 13 having the highest power within a drivable range of the battery cell 13, and specifically, in the case of the verification driving pattern, the worst case may be determined to be a driving pattern due to the use of a battery which uses the highest power and a high temperature within the drivable range of the battery in a conventional system and a new system by building vehicle simulation in which a vehicle drives on a specific circuit.

In addition, as described above, the control unit 100 may actively determine the verification driving pattern from a plurality of driving patterns, receive a predetermined driving pattern through the communication unit 200, and determine that the received driving pattern is the verification driving pattern.

A driving pattern-specific standard capacity change rate determination unit 102 of the control unit 100 may determine the standard capacity change rate in each of the first driving mode (the normal driving mode) and the second driving mode (the high-power driving mode) which are included in the driving mode. In this case, the standard capacity change rate may be determined by the control unit 100 assuming that the battery is used based on the verification driving pattern in each mode.

In this case, since the standard capacity of the battery may decrease over time and vary depending on a use pattern of the battery, the control unit 100 may compare the standard capacity change rates that vary depending on the driving mode and calculate the life influence degree of the battery.

Specifically, the control unit 100 may determine a capacity decrease rate over time as the standard capacity change rate, and the standard capacity change rate may be calculated by subtracting a current capacity from an initial capacity of the battery and dividing the above value by the initial capacity.

A driving pattern-specific resistance change rate determination unit 103 of the control unit 100 may determine the resistance change rate in each of the first driving mode (the normal driving mode) and the second driving mode (the high-power driving mode). In this case, the resistance change rate may be determined by the control unit 100 assuming that the battery is used by the verification driving pattern in each mode.

In this case, the resistance change rate refers to a change in internal resistance of a battery and may increase over time. Since the resistance change rate may increase based on an increase in temperature or an increase in temperature difference, the control unit 100 may calculate the life influence degree of the battery based on the resistance change rate inside the battery changed by changes in upper limit values of a temperature and current.

Specifically, the control unit 100 may receive an internal resistance value of the battery from a resistance sensor for measuring the internal resistance of the battery, calculate a degree to which the internal resistance value of the battery varies over time, and determine the resistance change rate for each driving mode.

A life influence degree determination unit 104 of the control unit 100 may determine a degree of influence on a life based on the standard capacity change rate and resistance change rate which are determined for each driving mode. That is, to determine the life influence degree when the battery is used in the second driving mode (the high-power driving mode), the control unit 100 may compare the standard capacity change rates and resistance change rates of the first driving mode (the normal driving mode) and the second driving mode (the high-power driving mode) and may also consider the temperature difference inside the battery cell 13 together.

The control unit 100 may determine the life influence degree of the second driving mode (the high-power driving mode) and transmit the determined life influence degree of the battery or the life of the battery to the external device 3. Accordingly, a user or battery manager using the battery can easily confirm the influence degree to which the upper limit current value of a current and the upper limit value of a temperature which are increased in the high-power driving mode affects the life of the battery.

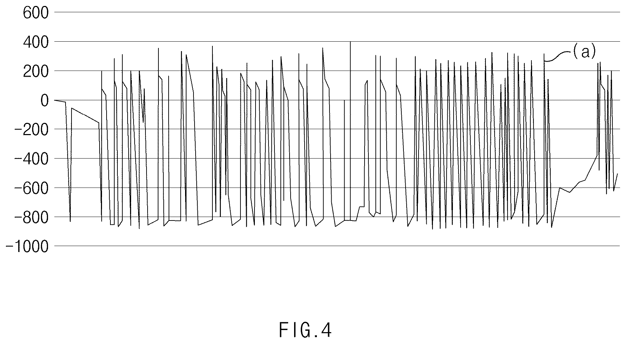

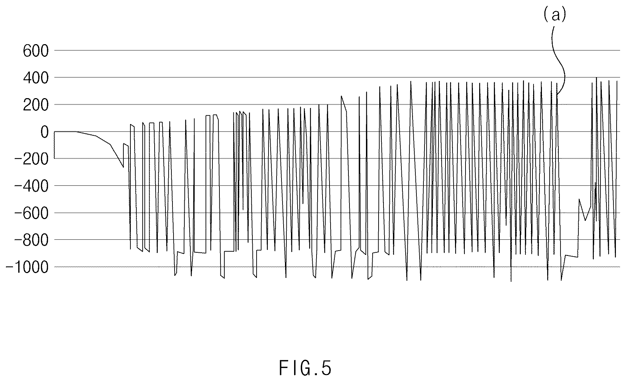

FIGS. 4 and 5 are views illustrating charging/discharging profiles of different driving modes used in the battery test device according to one embodiment.

The control unit 100 may store driving data on driving specifications of the battery cell 13 and upper limit values of specific parameters in the memory 120 for each driving mode. That is, the control unit 100 may separately maintain the upper limit value of each of the current or temperature, which varies in the normal driving mode and the high-power driving mode, and use the corresponding specific parameter when a battery test is performed in each driving mode.

Accordingly, referring to (a) of FIG. 4, the control unit 100 may generate a charging/discharging profile based on the driving data stored in the memory 120 in the first driving mode (the normal driving mode). In addition, referring to (a) o f FIG. 5, the control unit 100 may generate a charging/discharging profile based on the driving data stored in the memory 120 in the second driving mode (the high-power driving mode).

Based on the charging/discharging profile derived in FIGS. 4 and 5, the control unit 100 may calculate limit conditions within a battery life cycle when the battery is used with a verification driving pattern. For example, to match an actual use environment of the battery with a test environment, the control unit 100 may set the time exceeding a reference upper limit temperature value to 2 minutes when the verification driving pattern is repeated once and to up to 10 hours within the battery life cycle. In addition, the number of times the high-power driving mode may be set within the battery life cycle may be specified as up to 144 times.

In this way, since the control unit 100 may similarly simulate the actual use environment of the battery during the process of verifying the battery, the control unit 100 may derive the influence of the high-power driving mode on the degree of aging of the battery similarly to the actual use of the battery.

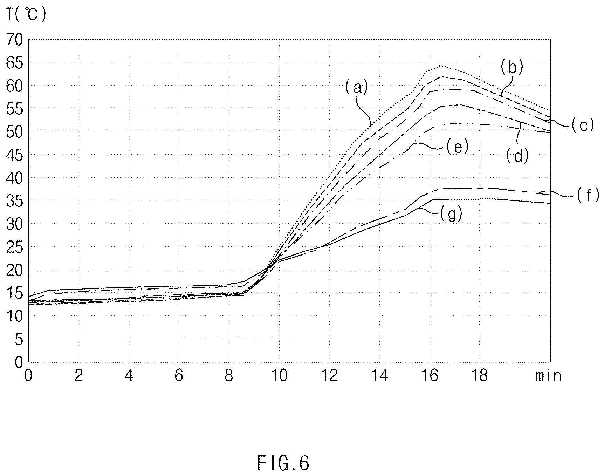

FIG. 6 is a view illustrating a temperature difference occurring in the battery test device according to one embodiment.

A simulation kit included in the battery test device 1 may include a plurality of temperature sensors for detecting the temperature difference of the battery cell 13. That is, unlike the related art, the battery test device 1 according to one embodiment may simulate the temperature difference of the battery positioned inside the vehicle in the actual driving environment and thus determine the life influence degree of the battery similar to the actual driving environment.

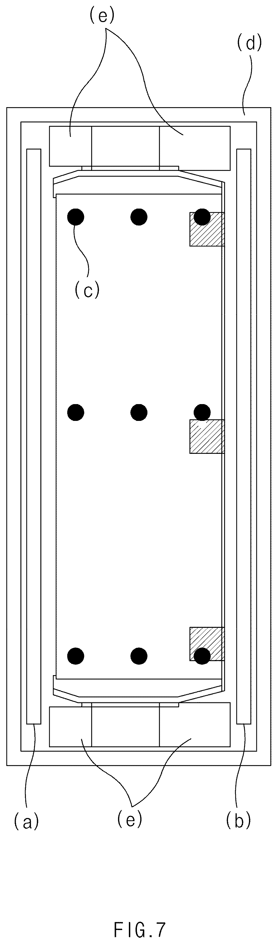

To this end, the simulation kit may have a temperature sensor at each point of the battery cell 13 as illustrated in FIG. 7. In this case, the temperature sensors may be provided at points at which the temperature sensors are positioned farthest from each other in the battery cell 13.

That is, as illustrated in FIG. 6, the control unit 100 may receive temperatures at different points of the single battery cell 13 from the temperature sensors (a) to (g). In this way, the temperature difference may occur in various ways even in the single battery cell 13, and the battery test device 1 according to one embodiment may consider the temperature difference of the battery cell 13 during the battery test process and thus more accurately pre-verify the life influence degree of the battery.

Referring to (a) and (g) of FIG. 6, the control unit 100 may detect the maximum temperature difference of 27 at about 16 minutes after the use of the battery starts. In addition, the control unit 100 may detect that a significant temperature difference of 15 or more, which may affect the life of the battery, continues for 6 minutes, when the battery cell 13 is used once with the verification driving pattern.

In this way, since the control unit 100 may detect the temperature difference of the battery cell 13 including the maximum temperature difference and compare the life influence degree of the battery according to the driving mode in a situation in which the temperature difference of the battery cell 13 occurs, a battery designer may specifically set a limit temperature and a limit current and reflect the limit temperature and the limit current in the warranty of the battery later.

FIG. 7 illustrates the battery test device included in the battery test device according to one embodiment.

Referring to FIG. 7, the simulation kit included in the battery test device 1 may include a heating pad (a), a cooling line (b), a temperature sensor (c), an insulation pad (d), and an insulation material (e). Accordingly, the simulation kit may provide an environment in which the battery cell 13 is tested in an environment similar to actual vehicle driving.

Since the temperature difference is not applied to the battery cell 13 in the battery test environment, the heating pad (a) included in the simulation kit may be provided to heat one surface of the battery cell 13 to generate an artificial temperature difference in the battery cell 13. For example, the heating pad (a) may include an electric heater, a heat pump, or a heater and heat the one surface of the battery cell 13 to retain the temperature at 70 °C.

Like the heating pad (a), the cooling line (b) included in the simulation kit may be provided to cool the one surface of the battery cell 13 to generate an artificial temperature difference in the battery cell 13. For example, the cooling line (b) may include a cooling pipe or cooler in which coolant flows and cool the one surface of the battery cell 13 to retain the temperature at 25 °C.

That is, the battery test device 1 according to one embodiment may additionally consider the temperature difference in the test environment of the battery cell 13 by including the heating pad (a) and the cooling line (b).

In addition, the simulation kit may include a plurality of temperature sensors (c). As described above, the plurality of temperature sensors (c) may measure a temperature of each portion of the battery cell 13 to measure the temperature difference inside the battery chamber and may be provided at positions farthest from each other.

In addition, since the simulation kit more easily dissipates heat in the test environment than in the actual use environment of the battery, the insulation pad (d) and the insulation material (e) may be formed to surround the battery cell 13.

For example, the insulation pad (d) may include a plate formed of a bakelite material formed of a preset thickness, and the insulation material (e) may include a polyurethane foam formed of a preset thickness.

That is, the battery test device 1 according to one embodiment may consider an insulation environment in the test environment of the battery cell 13 by including the insulation pad (d) and the insulation material (e).

Accordingly, the battery test device 1 may simulate an environment similar to the actual use environment of the battery, and thus derive a difference in life influence degrees in the first driving mode (the normal driving mode) and the second driving mode (the high-power driving mode) in an environment similar to the actual use environment.

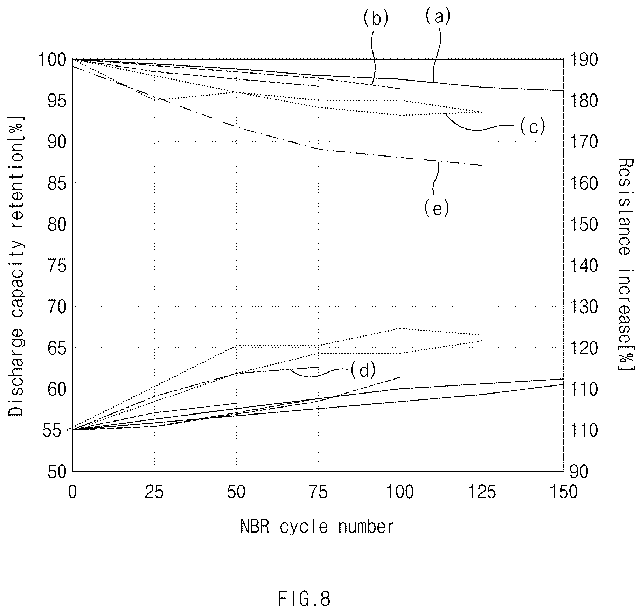

FIG. 8 is a view illustrating a discharge capacity retention rate and a resistance increase rate considering the temperature difference by the battery test device according to one embodiment.

Referring to FIG. 8, an x-axis may represent the number of cycles of a verification driving pattern (NBR), and a y-axis may represent a standard capacity change rate and a resistance change rate.

In a plurality of graphs, (a) and (c) may represent the result of driving the verification driving pattern with a middle of life (mol) cell, and (b) and (d) may represent the result of driving the verification driving pattern with a beginning of life (bol) cell. In addition, (e) represents a standard capacity change rate graph when the influence of a temperature difference is considered.

Here, a mol cell may be a battery cell assuming that a vehicle drives for a preset reference number of years at a capacity maintenance rate and resistance increase rate expected within a warranty period.

For example, assuming that a warranty period is set to a time point at which it first reaches among driving of 8 years and 160,000 km, the mole cell may be a battery cell when the vehicle has driven for 4 years at an expected capacity retention rate of 80% and an expected resistance increase rate of 130% of a cell.

In addition, the bol cell may be an unaged battery cell at the time of factory shipment.

In this way, to overcome the difficulty of a vehicle driver predicting how much of a cell has been aged before using the high-power mode, the battery test device according to one embodiment may perform tests on both the mole cell and the bol cell to simulate various cell environments and use the result of the test.

That is, referring to (a) to (d) of FIG. 8, as the number of repetitions of the verification driving pattern of the battery increases, that is, as the use of the battery increases, the internal resistance may increase and the standard capacity may decrease.

However, upon considering the temperature difference as in the battery test device 1 according to one embodiment, the standard capacity change rate may decrease more than when the temperature difference is not considered, and as a result, the life influence degree may be determined.

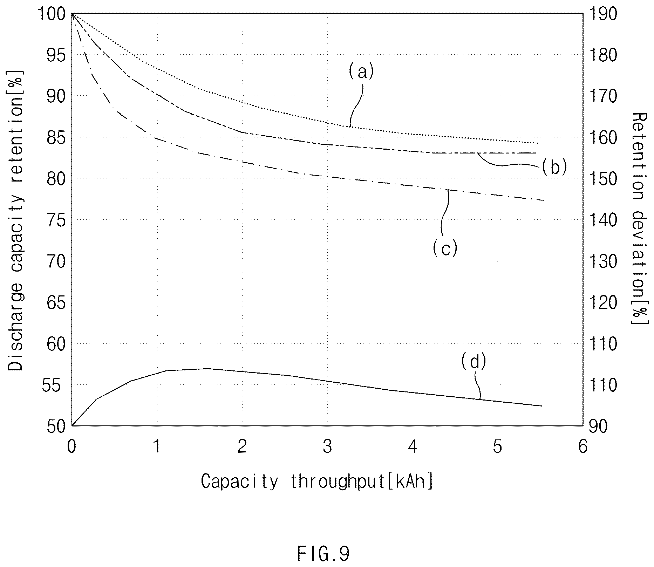

FIG. 9 is a view illustrating a degree of aging considering the temperature difference by the battery test device according to one embodiment.

Subsequently, referring to FIG. 9, an x-axis may represent discharge capability, which is the maximum amount of power capable of being transmitted per unit time, and a y-axis may represent a standard capacity change rate and power retention capability.

In a plurality of graphs, (a) may represent a high-power driving mode in which a general vehicle may drive, and (b) may represent a high-power driving mode in which a premium vehicle may drive and represent an embodiment in which the temperature of the battery cell extends to a range of 70 degrees or less, which may represent an embodiment in which an average speed is higher than that of (a).

In addition, (c) may represent a case in which a temperature difference is considered in the second driving mode (the high-power driving mode), and (d) may graphically represent a difference in capacity retention rates between (a) and (b).

That is, upon comparing (a) to (b) of FIG. 9, as the discharge capacity of the battery increases, the standard capacity decreases, the power retention capability may decrease, and a difference in the capacity retention rate may occur as in (d). However, upon considering the temperature difference as in the battery test device 1 according to one embodiment, the standard capacity change rate decreases more than when the temperature difference is not considered, and as a result, the life influence degree may be determined, and the difference in the capacity retention rates may be graphically illustrated as in (d) to analyze the influence of a capacity difference on the life influence degree.

In this way, as in FIGS. 8 and 9, according to the battery test device 1 according to one embodiment, since the temperature difference inside the battery cell 13 may be considered by the simulation kit, it is possible to estimate the degree of aging and life influence degree of a battery with higher accuracy.

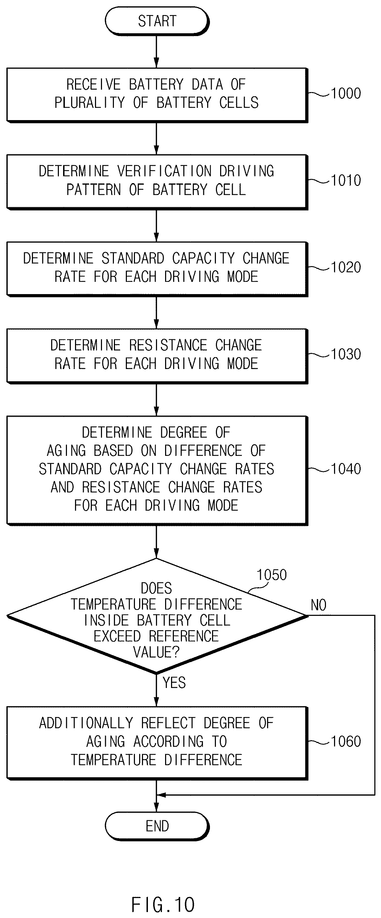

FIG. 10 is a control flowchart of a battery test method according to one embodiment.

Referring to FIG. 10, the control unit 100 may receive the battery data of the plurality of battery cells 13 (1000) and determine the verification driving pattern of the battery cell 13 (1010). In this case, the verification driving pattern may include a driving pattern in which an existing temperature value and current value for verifying the battery cell 13 are increased.

Thereafter, the control unit 100 may determine a standard capacity change rate for each driving mode (1020) and determine a resistance change rate for each driving mode (1030). The control unit 100 may determine the degree of aging of the battery based on a difference between the standard capacity change rates for each driving mode and a difference between the resistance change rates for each driving mode (1040) and determine the life influence degree of the battery based on the degree of aging.

In this case, as described in FIGS. 8 and 9, since the result values similar to the actual use environment of the battery may be obtained only when the temperature difference of the battery cell 13 itself is considered, the control unit 100 may determine whether the temperature difference inside the battery cell 13 exceeds a reference value (1050).

When the control unit 100 determines that the temperature difference inside the battery cell 13 exceeds the reference value by the simulation kit (Yes in 1050), the degree of aging according to the temperature difference may be additionally reflected in the life influence degree of the battery (1060).

Thereafter, a battery designer may set a battery warranty to be provided to a battery user based on the acquired life influence degree of the battery. That is, before the battery cell 13 is sold to the user, the battery cell 13 may be pre-verified by the battery test device 1 according to one embodiment, and the life influence degree of the battery derived from the result of the verification may be reflected in the battery warranty, thereby maximizing user satisfaction and a profit of a battery seller.

Meanwhile, disclosed embodiments may be implemented in the form of a recording medium in which commands executable by a computer are stored. The commands may be stored in the form of program code, and when executed by a processor, program modules are generated to perform operations of the disclosed embodiments. The recording medium may be implemented as a computer-readable recording medium.

The computer-readable recording medium includes any type of recording media in which commands which may be decoded by a computer are stored. For example, there may be a ROM, a RAM, a magnetic tape, a magnetic disk, a flash memory, an optical data storage device, etc.

In addition, the computer-readable storage medium may be provided in the form of a non-transitory storage medium. Here, "non-transitory" is a tangible device and only means not including a signal (e.g., electromagnetic waves), and this term does not distinguish between cases in which data is stored semi-permanently and temporarily in the storage medium. For example, "non-temporary storage medium" may include a buffer in which data is temporarily stored.

According to one embodiment, a method according to various embodiments disclosed herein may be provided by being included in a computer program product. The computer program product may be traded between sellers and buyers as commodities. The computer program product may be distributed in the form of a device-readable storage medium (e.g., compact disc read only memory (CD-ROM)) or distributed online (e.g., downloading or uploading) via an application store (e.g., Play Store^{™}) or directly between two user devices (e.g., smartphones). In the case of the online distribution, at least some of the computer program products (e.g., a downloadable app) may be at least temporarily stored or temporarily generated in a device-readable storage medium such as a memory of a server of a manufacturer, a server of an application store, or a relay server.

Although all the components constituting the embodiments disclosed herein were described above as being operated by being coupled to one or being coupled, the embodiments disclosed herein are not necessarily limited to these embodiments. In other words, one or more of all the components may be operated by being selectively coupled without departing from the scope of the purpose of the embodiments disclosed herein.

In addition, the terms such as "comprise," "constitute," or "have" described above mean that the corresponding component can be included unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present document without departing from the essential characteristics of the embodiments disclosed herein. Therefore, the embodiments disclosed herein are not intended to limit the technical spirit disclosed herein but are intended to describe the same, and the scope of the technical spirit disclosed herein is not limited by these embodiments. The scope of the technical spirit disclosed herein should be construed by the appended claims, and all technical ideas within the equivalent range should be construed as being included in the scope of the present document.

### [DESCRIPTION OF REFERENCE NUMERALS]

1: battery test device
2: voltage sensor
3: external device
10: battery system
12: a plurality of battery modules
13: battery cell
14: sensor unit
16: switching unit
20: upper-level controller
100: controller
110: processor
120: memory
200: communication unit
210: wireless communicator
220: wired communicator

## Claims

1. A battery test device comprising:
a communication unit configured to acquire battery data from a battery cell; and
a control unit configured to determine a verification driving pattern related to a test of the battery cell, reflect a temperature difference of the battery cell to acquire test data, acquire a standard capacity change rate and a resistance change rate of the battery cell in each of a first driving mode and a second driving mode based on the test data, and compare the standard capacity change rates and the resistance change rates to determine a life influence degree of the battery cell.

2. The battery test device of claim 1, wherein the control unit compares the standard capacity change rates and the resistance change rates based on the temperature difference of the battery cell in the first driving mode and the second driving mode being a reference difference or more.

3. The battery test device of claim 2, wherein the control unit determines the life influence degree of the battery cell based on a time for which the temperature difference exceeds the reference difference being a reference time or longer.

4. The battery test device of claim 3, wherein the control unit determines the life influence degree based on a condition in which driving of the battery cell is stopped being satisfied within the reference time.

5. The battery test device of claim 1, wherein the control unit acquires the test data from a simulation kit including a plurality of temperature sensors.

6. The battery test device of claim 5, wherein the control unit acquires the test data from the simulation kit including a heating pad formed so that one surface of the battery cell reaches a preset first threshold temperature and a cooling line formed so that the other surface of the battery cell reaches a preset second threshold temperature.

7. The battery test device of claim 6, wherein the control unit acquires the test data from the simulation kit provided so that an insulation pad formed to retain a temperature of the battery at a predetermined temperature or higher surrounds the battery cell.

8. The battery test device of claim 1, wherein the verification driving pattern includes a driving pattern of a case in which a vehicle drives with the battery cell having highest power within a drivable range of the battery cell.

9. A battery test method comprising:
acquiring battery data from a battery cell;
determining a verification driving pattern related to a test of the battery cell;
reflecting a temperature difference of the battery cell to acquire test data;
acquiring a standard capacity change rate and a resistance change rate of the battery cell in each of a first driving mode and a second driving mode based on the test data; and
comparing the standard capacity change rates and the resistance change rates to determine a life influence degree of the battery cell.

10. A battery test system comprising:
a battery cell included in a battery module;
a simulation kit configured to reflect a temperature difference of the battery cell; and
a battery test device configured to reflect the temperature difference to acquire test data obtained by testing the battery cell with the verification driving pattern, acquire a standard capacity change rate and a resistance change rate of the battery cell in each of a first driving mode and a second driving mode based on the test data, compare the standard capacity change rates and the resistance change rates, and determine a life influence degree of the battery cell in each of the first driving mode and the second driving mode.

11. The battery test system of claim 10, wherein the battery test device compares the standard capacity change rates and the resistance change rates based on the temperature difference of the battery cell in the first driving mode and the second driving mode being a reference difference or more.

12. The battery test system of claim 11, wherein the battery test device determines the life influence degree of the battery cell based on a time for which the temperature difference exceeds the reference difference being a reference time or longer.

13. The battery test system of claim 12, wherein the battery test device determines the life influence degree based on a condition in which driving of the battery cell is stopped being satisfied within the reference time.

14. The battery test system of claim 10, wherein the simulation kit includes a plurality of temperature sensors configured to detect the temperature difference of the battery cell.

15. The battery test system of claim 10, wherein the simulation kit includes a heating pad formed so that one surface of the battery cell retains a preset first threshold temperature and a cooling line formed so that the other surface of the battery cell retains a preset second threshold temperature.

16. The battery test system of claim 10, wherein the simulation kit is provided so that an insulation pad formed to retain a temperature of the battery at a predetermined temperature or higher surrounds the battery cell.

17. The battery test system of claim 10, wherein the verification driving pattern includes a driving pattern of a case in which a vehicle drives with the battery cell having highest power within a drivable range of the battery cell.
